# EUROPEAN PATENT APPLICATION

(11) **EP 4 273 908 A1**
(43) Date of publication of application: **08.11.2023**
(21) Application number: 22171599.8
(22) Date of filing: 04.05.2022
(51) Int. Cl.: H01L 21/56, H01L 21/28, H01L 23/31, H01L 23/538

(54) **A METHOD FOR FABRICATING A SEMICONDUCTOR DEVICE MODULE WITH INCREASED RELIABILITY AND A SEMICONDUCTOR DEVICE MODULE**

(71) Applicant: Infineon Technologies Austria AG, 9500 Villach (AT)
(72) Inventor: SCHMOELZER, Bernd, 9545 Radenthein (AT); FUERGUT, Edward, 86453 Dasing (DE); NIKITIN, Ivan, 93057 Regensburg (DE); SCHOLZ, Wolfgang, 82140 Olching (DE)
(74) Representative: Lambsdorff & Lange Patentanwälte Partnerschaft mbB

(57) **Abstract**

A method (100) for fabricating a semiconductor device module, the method comprising providing a first encapsulant layer and a core layer disposed on the first encapsulant layer wherein the core layer comprises an opening (110), disposing a semiconductor device in the opening, the semiconductor device comprising a die carrier and a semiconductor die disposed on the die carrier (120), dispensing an encapsulant onto the semiconductor device (130), applying a second polymer layer onto the encapsulant so that the encapsulant is pressed into the opening (140); and laminating together the first and second encapsulant layers and the encapsulant (150).

## Description

### TECHNICAL FIELD

The present disclosure is related to a method for fabricating a semiconductor device module and to a semiconductor device module.

### BACKGROUND

Over the last couple of years a lot of activities have been carried out concerning the embedding of passive components and active semiconductor dies into PCB or package carrier systems. Some low voltage use cases have found their way into production as embedding provides additional value compared to module or discrete packaging solutions, such as compactness (power density), short lead lengths leading to remarkably low parasitic inductances, good thermal management and significantly improved power cycling capability. These benefits are also seen to be attractive for power applications with high voltages up to 1200 V and specially for fast switching applications > 20 kHz. Nevertheless, some existing blocking points, when looking at how chip embedding is done today, have to be solved first as in the future peak voltages of 1700V, 2000V or even higher are under consideration.

The current chip embedding process does not fulfil high voltage application requirements. The breakdown voltage, ion impurity level (sodium, chlorine, etc.) and the overall other properties of current PCB materials that are used for chip embedding limit the reliability of 650 V (or even below) devices. One of the further problems is also the insufficient adhesion of polymer layers like prepreg layers to the core layer of the PCB and of the semiconductor device to the polymer layers and possible local delamination of these components.

For these and other reasons there is a need for the present disclosure.

### SUMMARY

A first aspect of the present disclosure is related to a method for fabricating a semiconductor device module, the method comprising providing a first encapsulant layer and a core layer disposed on the first encapsulant layer wherein the core layer comprises an opening, disposing a semiconductor device in the opening, the semiconductor device comprising a die carrier and a semiconductor die disposed on the die carrier, dispensing an encapsulant onto the semiconductor device, applying a second encapsulant layer onto the encapsulant so that the encapsulant is pressed into the recess, and laminating together the first and second encapsulant layers and the encapsulant.

A second aspect of the present disclosure is related to a semiconductor device module comprising a core layer comprising an opening, a semiconductor device disposed in the opening, an encapsulant filled into the opening and at least partly embedding the semiconductor device, a first encapsulant layer disposed on a first main face of the core layer, and a second encapsulant layer disposed on a second main face of the core layer, the second main face being opposite to the first main face, wherein the encapsulant comprises one or more exit areas located outside of the opening in intermediate spaces between the core layer and one or both of the first encapsulant layer and the second encapsulant layer.

A third aspect of the present disclosure is related to a method for fabricating a device module the method comprising providing a first encapsulant layer and a core layer disposed on the first encapsulant layer wherein the core layer comprises an opening, providing a device and covering the device at least in part with an encapsulant, the encapsulant comprising a B-stage compound or another mold compound which comprises reactive or conditioned surfaces, disposing the device with the encapsulant in the opening, applying a second encapsulant layer onto the core layer and the encapsulant in the opening; and laminating together the first and second encapsulant layers and the encapsulant.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 shows a flow diagram of an exemplary method for fabricating a semiconductor device module according to the first aspect.
Fig. 2 comprises Fig. 2A to 2E and shows schematic cross-sectional side view representations of intermediate products and a semiconductor device module for illustrating an example of an exemplary method for fabricating a semiconductor device module according to the first aspect.
Fig. 3 shows a flow diagram of an exemplary method for fabricating a device module according to the third aspect.
Fig. 4 comprises Fig. 4A to 4E and shows schematic cross-sectional side view representations for illustrating an example of an exemplary method for fabricating a device module according to the third aspect.

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", "leading", "trailing", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

### DETAILED DESCRIPTION

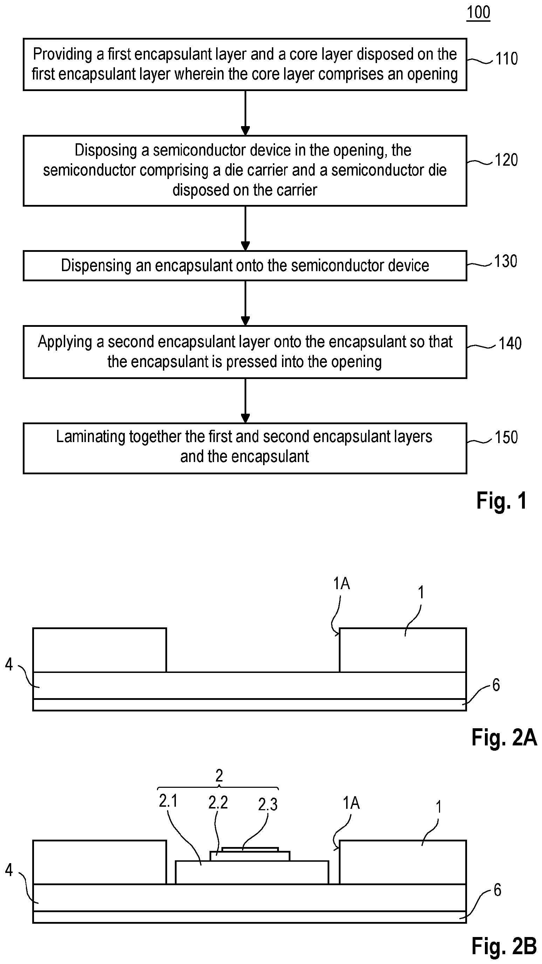

Fig. 1 shows a flow diagram of an exemplary method for fabricating a semiconductor device module according to the first aspect.

More specifically, Fig. 1 shows a method 100 for fabricating a semiconductor device module, the method comprising providing a first encapsulant layer and a core layer disposed on the first encapsulant layer wherein the core layer comprises an opening (110), disposing a semiconductor device in the opening, the semiconductor device comprising a die carrier and a semiconductor die disposed on the die carrier (120), dispensing an encapsulant onto the semiconductor device (130), applying a second encapsulant layer onto the encapsulant so that the encapsulant is pressed into the opening (140), and laminating together the first and second encapsulant layers and the encapsulant (150).

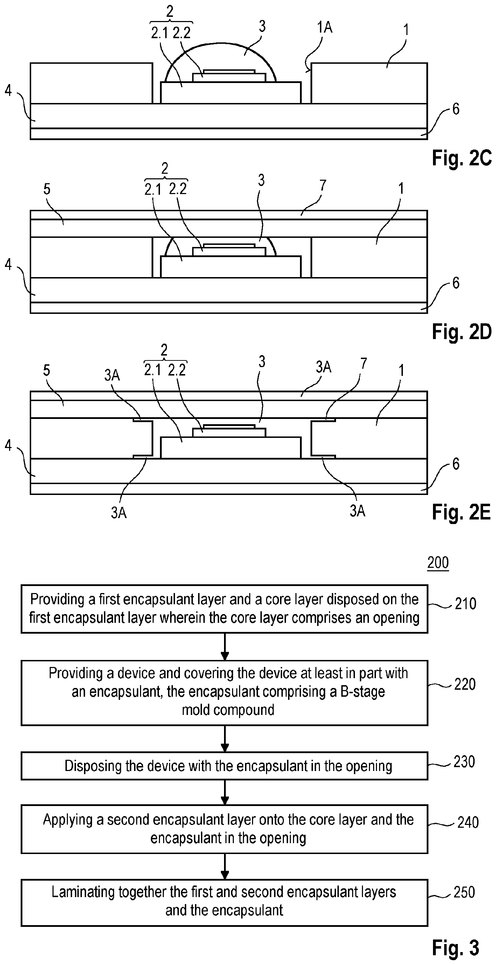

Fig. 2 comprises Fig. 2A to 2E and shows schematic cross-sectional side view representations for illustrating an example of an exemplary method for fabricating a semiconductor device module according to the first aspect.

More specifically, Fig. 2A shows an intermediate product comprising a core layer 1 comprising a recess or opening 1A, the core layer 1 being disposed on a first encapsulant layer 4. The core layer 1 can, for example, comprise an FR1, FR2, FR3, or FR4 material, a BT-Epoxy (where BT stands for bismaleimidtriazine), a polyimide, or a cyanate ester. The first encapsulant layer 4 may comprise a first polymer, in particular a first prepreg layer 4. A first Cu layer 6 may be disposed on a rear surface of the first encapsulant layer 4 remote from the core layer 1.

Fig. 2B shows an intermediate product after placing a semiconductor device 2 into the opening 1A of the core layer 1. The semiconductor device 2 comprises a die carrier 2.1, and a semiconductor die 2.2 attached to the die carrier 2.1. In general the semiconductor device 2 can be non-isolated wherein the die carrier 2.1 can be a leadframe, a copper block etc. The semiconductor device 2 can also be isolated e.g. like a DCB (direct copper bond), an AMB (active metal braze, an IMS (insulated metal substrate), or a pre-laminated package or a fullpack (isolated by thermal conductive encapsulant) .

The semiconductor die 2.2 may comprise a semiconductor transistor die 2.2 like, e.g. one or more of an IGBT, a MOSFET die, a CoolMOS, or a wide band gap semiconductor transistor like SiC-MOS, or GaN-MOS. The semiconductor transistor die 2.2 may comprise a contact pad 2.2A on an upper surface thereof, which contact pad 2.2A can be, for example, a source pad 2A. Further contact pads may be arranged on the upper surface of the semiconductor transistor die 2.2 like, e.g., a gate pad or a source sense pad.

At this point it should be mentioned here that instead of a semiconductor component, another component can also be installed in the module in the manner described. For example, a passive component such as a diode, a capacitor or a resistor can be used. Also a heat sink in the form of a copper insert can be used. A conductor rail or bus bar is also conceivable for use.

Fig. 2C shows an intermediate product after dispensing an encapsulant 3 onto the semiconductor device. The encapsulant 3 comprises a material which can in general be a material out of the group of adhesives like, for example, a duromer, an elastomer or a thermoplastic. The encapsulant 3 can also be one or more of a liquid mold compound, a resin, an organic resin, an epoxy resin, an inorganic resin, a polyimide, a cyanate ester, a silicone, or mixtures of the above components.

The encapsulant 3 can also be made of one of the above mentioned materials and furthermore being filled with special filler particles, e.g. for instance comprising or consisting of metal oxide or metal nitride filler particles, in particular AlO, SiO, ZrO₂, Si₃N₄, BN, AlN, or diamond.

Fig. 2D shows an intermediate product immediately after a first stage of applying a second encapsulant layer 5 onto the core layer 1 and the encapsulant 3 and simultaneously laminating together the first and second encapsulant layers 4 and 5 and the encapsulant 3. The application of the second encapsulant layer 5 results in that the encapsulant 3 is pressed into the opening 1A and embeds the semiconductor device 2. This process step therefore involves laminating of the first and second encapsulant layers 4 and 5, which additionally includes compression molding properties. In particular, by laminating the first and second encapsulant layers 4 and 5, the two encapsulant layers 4 and 5 are connected with each other. Like the first encapsulant layer 4, the second encapsulant layer 5 may comprise a polymer layer, in particular a prepreg layer 5 and have a copper layer 7 on its surface facing away from the core layer 1. The copper layer 7 comprises conductive areas or traces which are connected by electrical vias in the second encapsulant layer 5 with the contacts pads of the semiconductor die. The electrical vias can be fabricated by laser drilling and subsequent filling of the vias with copper by chemical galvanic plating.

The encapsulant layers 4 and 5 can both contain standard filler particles, e.g. SiO, but also thermal conductive filler particles, e.g. Al2O3, BrN etc. The encapsulant layers 4 and 5 can have different properties, wherein most likely is that the second encapsulant layer 5 contains standard fillers, and the first encapsulant layer 4 contains thermal conductive fillers for proper heat dissipation.

Fig. 2E shows a semiconductor device module after completion of the combined laminating and compression molding step. It can be seen that the encapsulant 3 has been filled into the space of the opening 1A which is not occupied by the semiconductor device 2. Moreover, it can be seen that the encapsulant 3 not only completely fills the opening 1A but has partially flowed out of the opening 1A during the compression molding step to form exit areas 3A located outside of the opening 1A in intermediate spaces between the core layer 1 the first and second encapsulant layers 4 and 5. In the embodiment shown in Fig. 2E, exit areas 3A of the encapsulant 3 are shown between the core layer 1 and both the first and second encapsulant layers 4 and 5. However, it is just as possible that these exit areas 3A only occur at isolated points between the core layer 1 and one or both of the two encapsulant layers 4 or 5.

During the combined lamination and compression molding process the previously dispensed encapsulant 3 flows into the opening 1A, i.e. into the area of the opening 1A which is not occupied by the semiconductor device 2. However, it should be mentioned that it can be the case that in addition to that also materials contained in the second encapsulant layer 5 may flow out of the second encapsulant layer 5 into the opening 1A. In particular, in case of a prepreg layer as the second encapsulant layer 5, resin material contained in the prepreg layer may flow out of the prepreg layer into the opening 1A. This means that an intermediate phase forms between the encapsulation 3 and the second prepreg layer 5, which ensures improved adhesion between the two layers and can help to avoid delaminations during later use of the semiconductor device module.

Fig. 3 shows a flow diagram of an exemplary method for fabricating a device module according to the third aspect.

More specifically, the method 200 as shown in Fig. 3 comprises providing a first encapsulant layer and a core layer disposed on the first encapsulant layer wherein the core layer comprises an opening (210), providing a device and covering the device at least in part with an encapsulant, the encapsulant comprising a B-stage mold compound or another mold compound which comprises reactive or conditioned surfaces (220), disposing the device with the encapsulant in the opening (230), applying a second encapsulant layer onto the core layer and the encapsulant in the opening (240), and laminating together the first and second encapsulant layers and the encapsulant (250).

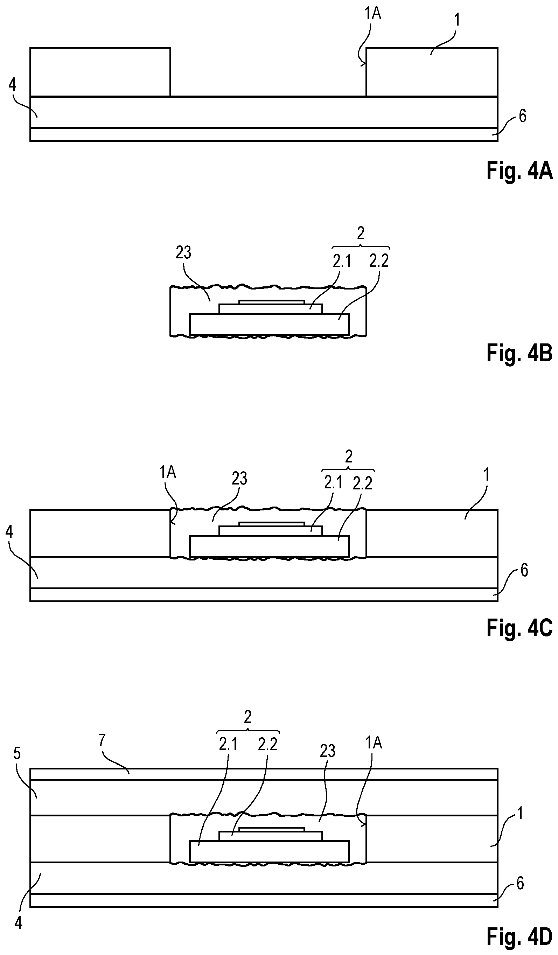

Fig. 4 comprises Fig. 4A to 4D and shows schematic cross-sectional side view representations of intermediate products and a semiconductor device module for illustrating an example of an exemplary method for fabricating a semiconductor device module according to the third aspect.

More specifically, Fig. 4A shows an intermediate product comprising a core layer 1 comprising a recess or opening 1A, the core layer 1 being disposed on a first encapsulant layer 4. The core layer 1 can, for example, comprise a FR1, FR2, FR3, or FR4 material, a BT-epoxy (where BT stands for bismaleimidtriazine), a polyimide, a cyanate ester, or a glass substrate. The core layer 1 can further comprise an organic material, an inorganic material, an electrically insulating or an electrically conductive material, in particular copper or aluminum. The first encapsulant layer 4 may comprise a first prepreg layer 4. A first Cu layer 6 may be disposed on a rear surface of the first encapsulant layer 4 remote from the core layer 1.

Fig. 4B shows an intermediate product after providing a semiconductor device 2 and covering the semiconductor device 2 at least in part with an encapsulant 23, the encapsulant 23 comprising a B-stage mold compound. The semiconductor device 2 comprises a die carrier 2.1, and a semiconductor die 2.2 attached to the die carrier 2.1. In general the semiconductor device 2 can be non-isolated wherein the die carrier 2.1 can be a leadframe, a copper block etc. The semiconductor device 2 can also be isolated e.g. like a DCB (direct copper bond), an AMB (active metal braze, an IMS (insulated metal substrate), or a pre-laminated package or a fullpack (isolated by thermal conductive encapsulant).

The semiconductor die 2.2 may comprise a semiconductor transistor die 2.2 like, e.g. one or more of an IGBT, a MOSFET die, a CoolMOS, or a wide band gap semiconductor transistor like SiC-MOS, or GaN-MOS. The semiconductor transistor die 2.2 may comprise a contact pad 2.2A on an upper surface thereof, which contact pad 2.2A can be, for example, a source pad 2A. Further contact pads may be arranged on the upper surface of the semiconductor transistor die 2.2 like, e.g., a gate pad or a source sense pad.

The encapsulant 23 comprises an electrically insulating B stage compound which can be one or more of a resin, an epoxy resin, a duroplast, a polyimide, a BMI (bismaleimide), a silicone, a cyanate ester, or mixtures of the above. A B stage compound is in general a system wherein the reaction between the compound and the curing agent/hardener is not complete. Due to this, the system is in a partially cured stage. When this system is later reheated at elevated temperatures, the cross-linking is complete and the system fully cures.

In a stage as depicted in Fig. 4B, the degree of cure of the B stage epoxy compound 23 can, for example, be in a range from 20% to 60%, more specifically from 50% to 70% on average. In particular, at the main surfaces of the B-stage epoxy compound 23 the degree of cure can be less than at a center region. As can be seen in Fig. 4B, the low degree of cure leads to a frayed and structured surface of the epoxy compound 23. The B stage epoxy compound can be applied to the semiconductor device by transfer molding or compression molding, or other forming processes like printing, in particular 3D printing, or dispensing. In any case the forming process can be performed so that also on a lower surface of the die carrier 2.1 a thin layer of mold compound 23 can be applied which then also comprises a frayed and structured surface.

Fig. 4C shows an intermediate product after inserting the semiconductor device 2 together with the encapsulant 23 into the opening 1A of the core layer 1. The background to the use of a B-stage compound is as follows. A fully polymerized epoxy resin material results in slick surfaces which are unfavorable for adhesion to adjacent layers and can lead to delamination. Use of B stage mold material can solve this problem. In the next step of laminating the second polymer layer 5 the mold material in the lamination tool gets fluid and can intermix with both the first and second laminate layers 4 and 5. Active groups can undergo cross linking with the first and second polymer layers 4 and 5 and so improve adhesion.

Fig. 4D shows a semiconductor device module after laminating the second polymer layer 5 onto the core layer 1 and the encapsulant 23 in the opening 1A. The encapsulant 3 is fully cured after this lamination step. At the boundary between the encapsulant 23 and the first and second polymer layers 4 and 5, a cross-mixed or linked area has formed due to the mixing of the materials, which improves adhesion. Like the first polymer layer 4, the second polymer layer 5 may comprise a prepreg layer 5 and have a copper layer 7 on its surface facing away from the core layer 1. The copper layer 7 comprises conductive areas or traces which are connected by electrical vias in the second encapsulant layer 5 with the contacts pads of the semiconductor die. The electrical vias can be fabricated by laser drilling and subsequent filling of the vias with copper by chemical galvanic plating.

### EXAMPLES

In the following specific examples of the present disclosure are described.

Example 1 is a method for fabricating a semiconductor device module, the method comprising providing a first encapsulant layer and a core layer disposed on the first encapsulant layer wherein the core layer comprises an opening,-disposing a semiconductor device in the opening, the semiconductor device comprising a die carrier and a semiconductor die disposed on the die carrier, dispensing an encapsulant onto the semiconductor device, applying a second encapsulant layer onto the encapsulant so that the encapsulant is pressed into the opening, and laminating together the first and second encapsulant layers and the encapsulant.

Example 2 is the method according to Example 1, wherein one or both of the first encapsulant layer and the second encapsulant layer comprises a polymer layer or a prepreg layer, respectively.

Example 3 is the method according to Example 1 or 2, wherein the core layer comprises one of an FR1, FR2, FR3, or an FR4 material, a BT-epoxy, a polyimide, a cyanate ester, an organic material, an inorganic material, an electrically insulating material, or an electrically conductive material.

Example 4 is the method according to any one of the preceding Examples, wherein the encapsulant comprises a material which is one or more of:
one out of the group of adhesives, including a duromer, an elastomer and a thermoplastic, a liquid mold compound, a resin, an organic resin, an epoxy resin, an inorganic resin, a granulate, a polyimide, a silicone, a cyanate ester, or mixtures of the above components.

Example 5 is a semiconductor device module, comprising a core layer comprising an opening, a semiconductor device disposed in the opening, an encapsulant filled into the opening and at least partly embedding the semiconductor device, a first encapsulant layer disposed on a first main face of the core layer, and a second encapsulant layer disposed on a second main face of the core layer, the second main face being opposite to the first main face, wherein the encapsulant comprises one or more exit areas located outside of the opening in intermediate spaces between the core layer and one or both of the first polymer layer and the second encapsulant layer.

Example 6 is the semiconductor device module according to Example 5, wherein one or both of the first encapsulant layer and the second encapsulant layer comprise a polymer layer or a prepreg layer.

Example 7 is the semiconductor device module according to Example 5 or 6, wherein the core layer comprises one of an FR1, FR2, FR3, or an FR4 material, a BT-epoxy, a polyimide, a cyanate ester, an organic material, an inorganic material, an electrically insulating material, or an electrically conductive material.

Example 8 is the semiconductor device module according to any one of Examples 5 to 7, wherein the encapsulant comprises a material which is one or more of:
one out of the group of adhesives, including a duromer, an elastomer and a thermoplastic, a liquid mold compound, a resin, an organic resin, an epoxy resin, an inorganic resin, a granulate, a polyimide, a silicone, a cyanate ester, or mixtures of the above components.

Example 9 is the semiconductor device module according to any of Examples 5 to 8, further comprising a first copper layer disposed on an outer surface of the first encapsulant layer.

Example 10 is the semiconductor device module according to any of Examples 5 to 9, further comprising a second copper layer disposed on an outer surface of the second encapsulant layer.

Example 11 is a method for fabricating a device module, the method comprising providing a first encapsulant layer and a core layer disposed on the first encapsulant layer wherein the core layer comprises an opening, providing a device and covering the device at least in part with an encapsulant, the encapsulant comprising a B-stage mold compound or another mold compound which comprises reactive or conditioned surfaces, disposing the device with the encapsulant in the opening, applying a second encapsulant layer onto the core layer and the encapsulant in the opening, and laminating together the first and second encapsulant layers and the encapsulant.

Example 12 is the method according to Example 11, wherein the B-stage mold compound comprises a partial polymerization in a range from 20% to 60% or from 50% to 70%.

Example 13 is the method according to Example 11 or 12, wherein one or both of the first encapsulant layer and the second encapsulant layer comprises a prepreg layer.

Example 14 is the method according to any one of Examples 11 or 13, wherein the core layer comprises one of an FR1, FR2, FR3, or an FR4 material, a BT-epoxy, a polyimide, a cyanate ester, an organic material, an inorganic material, an electrically insulating material, or an electrically conductive material.

Example 15 is the method according to any one of Examples 11 to 14, wherein the device is one or more of a semiconductor device, a semiconductor transistor device, a passive device, a copper inset, or a bus bar,

Example 16 is the method according to any one of Examples 11 to 15, wherein the encapsulant comprises another mold compound in which the reactive or conditioned surfaces comprise frayed, structured, roughened, or plasma activated surfaces.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A method (100) for fabricating a semiconductor device module, the method comprising
- providing a first encapsulant layer and a core layer disposed on the first encapsulant layer wherein the core layer comprises an opening (110);
- disposing a semiconductor device in the opening, the semiconductor device comprising a die carrier and a semiconductor die disposed on the die carrier (120);
- dispensing an encapsulant onto the semiconductor device (130) ;
- applying a second encapsulant layer onto the encapsulant so that the encapsulant is pressed into the opening (140); and
- laminating together the first and second encapsulant layers and the encapsulant (150).

2. The method according to claim 1, wherein
one or both of the first encapsulant layer and the second encapsulant layer comprises a polymer layer or a prepreg layer, respectively.

3. The method according to any one of claim 1 or 2, wherein the core layer comprises one of an FR1, FR2, FR3, or an FR4 material, a BT-epoxy, a polyimide, a cyanate ester, an organic material, an inorganic material, an electrically insulating material, or an electrically conductive material.

4. The method according to any one of the preceding claims, wherein
the encapsulant comprises a material which is one or more of: one out of the group of adhesives, including a duromer, an elastomer and a thermoplastic,
a liquid mold compound,
a resin, an organic resin, an epoxy resin, an inorganic resin, a granulate, a polyimide, a silicone, a cyanate ester, or mixtures of the above components.

5. A semiconductor device module (10), comprising
a core layer (1) comprising an opening (1A);
a semiconductor device (2) disposed in the opening (1A);
an encapsulant (3) filled into the opening (1A) and at least partly embedding the semiconductor device (2);
a first encapsulant layer (4) disposed on a first main face of the core layer (1); and
a second encapsulant layer (5) disposed on a second main face of the core layer (1), the second main face being opposite to the first main face; wherein
the encapsulant (3) comprises one or more exit areas (3A) located outside of the opening (1A) in intermediate spaces between the core layer (1) and one or both of the first polymer layer (4) and the second encapsulant layer (5).

6. The semiconductor device module (10) according to claim 5, wherein
one or both of the first encapsulant layer (4) and the second encapsulant layer (5) comprise a polymer layer or a prepreg layer.

7. The semiconductor device module (10) according to claim 5 or 6, wherein
the core layer (1) comprises one of an FR1, FR2, FR3, or an FR4 material, a BT-epoxy, a polyimide, a cyanate ester, an organic material, an inorganic material, an electrically insulating material, or an electrically conductive material.

8. The semiconductor device module (10) according to any of claims 5 to 7, wherein
the encapsulant (3) comprises a material which is one or more of:
one out of the group of adhesives, including a duromer, an elastomer and a thermoplastic,
a liquid mold compound,
a resin, an organic resin, an epoxy resin, an inorganic resin, a granulate, a polyimide, a silicone, a cyanate ester, or mixtures of the above components.

9. The semiconductor device module (10) according to any of claims 5 to 8, further comprising
a first copper layer (6) disposed on an outer surface of the first encapsulant layer (4).

10. The semiconductor device module (10) according to any of claims 5 to 9, further comprising
a second copper layer (7) disposed on an outer surface of the second encapsulant layer (5).

11. A method (200) for fabricating a device module, the method (200) comprising
- providing a first encapsulant layer and a core layer disposed on the first encapsulant layer wherein the core layer comprises an opening (210);
- providing a device and covering the device at least in part with an encapsulant, the encapsulant comprising a B-stage mold compound or another mold compound which comprises reactive or conditioned surfaces (220);
- disposing the device with the encapsulant in the opening (230) ;
- applying a second encapsulant layer onto the core layer and the encapsulant in the opening (240); and
- laminating together the first and second encapsulant layers and the encapsulant (250).

12. The method (200) according to claim 11, wherein
the B-stage mold compound comprises a partial polymerization in a range from 20% to 60% or from 50% to 70%.

13. The method (200) according to claim 11 or 12, wherein one or both of the first encapsulant layer and the second encapsulant layer comprises a prepreg layer.

14. The method (200) according to any one of claim 11 or 13, wherein
the core layer comprises one of an FR1, FR2, FR3, or an FR4 material, a BT-epoxy, a polyimide, a cyanate ester, an organic material, an inorganic material, an electrically insulating material, or an electrically conductive material.

15. The method (200) according to any one of claims 11 to 14, wherein
the device is one or more of a semiconductor device, a semiconductor transistor device, a passive device, a copper inset, or a bus bar,

16. The method (200) according to any one of claims 11 to 13, wherein
the encapsulant comprises another mold compound in which the reactive or conditioned surfaces comprise frayed, structured, roughened, or plasma activated surfaces.
